# EUROPÄISCHE PATENTSCHRIFT

(11) **EP 4 089 726 B1**
(45) Veröffentlichungstag und Bekanntmachung des Hinweises auf die Patenterteilung: **10.12.2025**
(21) Anmeldenummer: 22172757.1
(22) Anmeldetag: 11.05.2022
(51) Int. Cl.: H01L 23/40, H01L 23/433, H01L 23/467, H01L 23/473, H05K 7/20

(54) **ANORDNUNG AUS KÜHLEINRICHTUNG UND KÜHLGEGENSTAND**
ASSEMBLY CONSISTING OF COOLING DEVICE AND COOLED ITEM
AGENCEMENT COMPOSÉ D'UN DISPOSITIF DE RÉFRIGÉRATION ET D'UN OBJET RÉFRIGÉRÉ

(30) Priorität: 12.05.2021 DE 102021112417
(43) Veröffentlichungstag der Anmeldung: 16.11.2022
(73) Patentinhaber: Erwin Quarder Systemtechnik GmbH, 32339 Espelkamp (DE)
(72) Erfinder: Siewert, Georg, 35415 Pohlheim (DE); Heitbrink, Alexander, 32351 Stemwede (DE)
(74) Vertreter: Geskes, Christoph

(56) Entgegenhaltungen:
- WO-A1-2005/088713
- JP-A- S6 381 959
- US-A- 5 150 274
- US-A- 6 111 749
- US-A1- 2012 080 785
- US-B2- 7 535 715

## Beschreibung

Die vorliegende Erfindung betrifft eine Anordnung mit einer Kühleinrichtung zum Abführen von Wärme von zu kühlenden Gegenständen, wie etwa von Leistungselektronikmodulen, die mindestens einen vorzugsweise starren, eine vorzugsweise ebene Wärmeaufnahmefläche aus Metall aufweisenden Kühlkörper zur Aufnahme von Wärme eines oder mehrerer zu kühlender Gegenstände aufweist, sowie einen Kühlfluidraum zur Aufnahme von Kühlfluid, insbesondere Kühlflüssigkeit, an das die von dem Kühlkörper aufgenommene Wärme weiterleitbar ist, und mit mindestens einem, eine vorzugsweise ebene Wärmeabgabefläche aus Metall aufweisenden zu kühlenden Gegenstand, insbesondere einem Leistungselektronikmodul.

Derartige Anordnungen aus zu kühlendem Gegenstand und Kühleinrichtung sind bekannt. Insbesondere, aber nicht nur wenn es sich bei den zu kühlenden Gegenständen um Leistungselektronikmodule handelt, ist es häufig notwendig, hohe Wärmeenergiemengen, die auf sehr geringem Raum entstehen, möglichst effizient abzuleiten, damit die zu kühlenden Gegenstände keinen Schaden nehmen. Im Stand der Technik werden die Wärmeabgabefläche des zu kühlenden Gegenstands und die Wärmeaufnahmefläche des Kühlkörpers einander gegenüberliegend angeordnet, wobei zur Optimierung der Wärmeübertragungsleistungen zwischen der Wärmeabgabefläche und der Wärmeaufnahmefläche Wärmeleitpasten bestimmter Dicke eingesetzt werden, die die Wärmeleitung nachteilig beeinflussende Luftpolster zwischen den Flächen verhindern bzw. verdrängen. Der Wärmeleitfähigkeit dieser Wärmeleitpasten sind allerdings materialbedingte Grenzen gesetzt.

Die US 7,535,715 B2 beschäftigt sich mit der Verbesserung von derartigen Wärmeleitpasten bzw. Wärmeleitmaterialien, insbesondere durch Verwendung bzw. Hinzufügen von Kohlenstoffpartikeln.

Die US 6,111,749 zeigt durch flexible Kühlmittelleitungen verbundene Kühlkörper, die auf zu kühlenden Bauteilen platziert werden. Die Flexibilität der Kühlmittelleitungen ermöglicht es, die Kühlkörper an unterschiedliche Höhen der zu kühlenden Bauteile anzupassen.

Es ist daher davon ausgehend Aufgabe der vorliegenden Erfindung, die eingangs genannte Anordnung weiterzuentwickeln, insbesondere mit Blick auf eine verbesserte Wärmeleitung zwischen der Wärmeabgabefläche und der Wärmeaufnahmefläche.

Diese Aufgabe wird gelöst durch eine Anordnung mit den Merkmalen des Anspruches 1. Eine erfindungsgemäße Anordnung ist dementsprechend dadurch gekennzeichnet, dass zur Optimierung der Wärmeleitung zwischen dem Kühlkörper und dem zu kühlenden Gegenstand die Wärmeaufnahmefläche des Kühlkörpers ohne Verwendung einer Zwischenschicht aus Luft verdrängendem Material (sowie insbesondere auch ohne Luft und/oder ohne stoffschlüssige Verbindung der Wärmeabgabefläche mit der Wärmeaufnahmefläche) unmittelbar an der Wärmeabgabefläche des zu kühlenden Gegenstands anliegt (Metall-Metall-Kontakt) oder allenfalls unter Verwendung einer allerdings nur sehr dünnen, insbesondere nur bereichsweise vorhanden Zwischenschicht aus Luft verdrängendem Material, insbesondere Wärmeleitmaterial, mit einer Maximaldicke < 2 µm, wobei
a) die Wärmeaufnahmefläche des Kühlkörpers und/oder die Wärmeabgabefläche des zu kühlenden Gegenstands derart bearbeitet ist, dass sie eine Rauheit Ra < 0,3 µm und/oder eine Ebenheit < 0,5 µm aufweist, und/oder wobei
b) die Wärmeaufnahmefläche des Kühlkörpers und die Wärmeabgabefläche des zu kühlenden Gegenstands mit einem Anpressdruck von mindestens 0,05 N/mm² aneinandergepresst sind.

Es hat sich überraschend gezeigt, dass die Umsetzung bereits einer der vorgenannten Maßnahmen zu einer gegenüber dem Stand der Technik stark verbesserten Wärmeleitung und somit deutlich verbesserten Kühlleistung der Kühleinrichtung führt. Eine Kombination dieser Maßnahme verbessert diese Effekte nochmals.

Erfindungsgemäß wird durch geeignete, ultrafeine Bearbeitung der Wärmeabgabefläche und der Wärmeaufnahmefläche (beispielsweise mittels Läppen, Hönen, Diamantfräsen etc.), mit der die angegebenen Rauheits- und/oder Ebenheitswerte erzielt werden können, erreicht, dass sich die metallischen Wärmeabgabe- und die Wärmeaufnahmeflächen entweder vollflächig oder mindestens in überwiegenden Teilbereichen direkt kontaktieren können, ohne dass sich - anders als im Stand der Technik - Luftpolster zwischen den Flächen aufbauen würden, die durch eine vergleichsweise dicke Schicht aus Wärmeleitmaterial verdrängt werden müssten, die sich mit Blick auf die Wärmeleitfähigkeit negativ auswirken würde. Entsprechend können erfindungsgemäß die hohen Wärmeleitfähigkeitswerte der beteiligten Metalle unmittelbar zum Tragen kommen. Hintergrund ist dabei, dass gängige Wärmeleitpasten in der Regel Wärmeleitfähigkeiten aufweisen, die gegenüber Wärmeleitfähigkeiten von Metallen zum Teil 100fach niedriger liegen.

Wobei es allerdings auch im Rahmen der Erfindung liegt, bei den angegeben Rauheits- und/oder Ebenheitswerte weiterhin eine voll- oder teilflächige Zwischenschicht aus dem Luft verdrängenden Material, insbesondere Wärmeleitmaterial zu verwenden, die allerdings im Vergleich zum Stand der Technik nur noch sehr dünn ausfällt bzw. ausfallen kann, nämlich < 2 µm.

Sie kann sogar nur eine Maximaldicke < 40 nm, vorzugsweise < 25 nm, besonders bevorzugt < 10 nm aufweisen.

Bei dem Luft verdrängenden Material der Zwischenschicht kann es sich beispielsweise um Wärmeleitpaste handeln oder um Wachs mit oder ohne in besonderer Weise wärmeleitenden Zugaben/Zuschlägen, wie etwa Graphitteilchen.

Wie sich weiter gezeigt hat, kann alternativ oder zusätzlich durch das oben genannte, erfindungsgemäße Verpressen der Wärmeabgabe- und die Wärmeaufnahmefläche mit Anpresskräften von > 0,05 N/mm² ebenfalls eine solche direkte (ganz oder teilflächige) Metall-Metall-Kontaktierung mit den genannten Vorteilen bewirkt werden. Dieses Verpressen kann im Übrigen Rauheiten und/oder Ebenheiten, die oberhalb der vorgenannten Werte liegen, ausgleichen und so auch als Alleinmaßnahme zu einer Optimierung der Wärmeleitung zwischen den genannten Flächen sorgen.

Besonders bevorzugt kann die Wärmeaufnahmefläche des Kühlkörpers und/oder die Wärmeabgabefläche des zu kühlenden Gegenstands erfindungsgemäß sogar derart (ultrafein-)bearbeitet sein, dass sie eine Rauheit Ra < 0,1 µm und/oder eine Ebenheit < 0,1 µm aufweist.

Zweckmäßigerweise liegen sich im Übrigen die Wärmeabgabefläche des zu kühlenden Gegenstands und die Wärmeaufnahmefläche des Kühlkörpers parallel gegenüber.

Gemäß einer bevorzugten Weiterbildung der Erfindung verfügt die Kühleinrichtung über mindestens zwei vorzugsweise starre Kühlkörper, die jeweils eine insbesondere durch ihre Unterseite gebildete (ebene) Wärmeaufnahmefläche aufweisen, und die insbesondere über ein Kühlkörpergelenk gelenkig miteinander verbunden sind, sodass die beiden Kühlkörper und mit ihnen die Wärmeaufnahmeflächen relativ zueinander in verschiedene, insbesondere parallele Ebenen bewegbar sind, wobei für jede Wärmeaufnahmefläche jedes Kühlkörpers gilt, dass sie jeweils an der Wärmeabgabefläche eines von zwei zu kühlenden Gegenständen ohne Verwendung der jeweiligen Zwischenschicht aus dem Luft verdrängenden Material unmittelbar anliegt oder allenfalls unter Verwendung der nur dünnen Zwischenschicht aus dem Luft verdrängenden Material.

Durch diese Verwendung von zwei untereinander gelenkig verbundenen Kühlkörpern und mithin auch zwei derart verbundenen, an dem jeweiligen zu kühlenden Gegenstand anzuordnenden Wärmeaufnahmeflächen, wird eine Kühleinrichtung geschaffen, die größere Toleranzen bzw. Abstände zwischen der bzw. den (ebenen bzw. planen) Wärmeaufnahmefläche(n) des jeweiligen Kühlkörpers und der oder den (ebenen bzw. planen) Wärmeabgabeflächen des oder der zu kühlenden Gegenstände ausgleichen kann, die sich andernfalls dadurch ergeben können, dass im Fall von mehreren getrennten Wärmeabgabeflächen diese nicht in einer gemeinsamen Ebene verlaufen, oder dass bezogen auf jeweils eine Wärmeabgabefläche diese einzelne Flächenbereiche aufweist, die in unterschiedlichen Ebenen verlaufen.

Infolgedessen ist es vorteilhafterweise auch nicht (mehr) notwendig, zur Überbrückung insbesondere solcher größerer Abstände Wärmeleitpaste großer Schichtdicke verwenden zu müssen.

Die Wärmeabgabeflächen der beiden zu kühlenden Gegenstände können dabei entsprechend in verschiedenen, insbesondere parallelen Ebenen angeordnet sein, wobei dann die ebenen Wärmeaufnahmeflächen der Kühlkörper, die an den Wärmeabgabeflächen anliegen, entsprechend ebenfalls in verschiedenen, insbesondere parallelen Ebenen angeordnet sein würden.

Was das vorgenannte Kühlkörpergelenk betrifft, so kann es zwei voneinander beabstandete, insbesondere parallele Drehachsen aufweisen, um die die beiden Kühlkörper relativ zueinander in die verschiedenen Ebenen bewegbar, nämlich verschwenkbar sind.

Das Kühlkörpergelenk kann des Weiteren einen flexiblen, insbesondere biegeweichen, bevorzugt plattenförmig ausgebildeten Gelenkabschnitt aufweisen, der entweder einstückig mit den Kühlkörpern verbunden ist und dabei über eine geringere Materialdicke verfügt als die beiden Kühlkörper, oder der einstückig verbunden ist mit einem Grundkörper, insbesondere aus Kunststoff, der mit den beiden Kühlkörpern insbesondere fluiddicht verbunden ist.

Der flexible Gelenkabschnitt kann dabei an zwei gegenüberliegenden Seiten jeweils angrenzen an einen von zwei Verbindungsabschnitten, mit dem er einstückig verbunden ist, wobei jeder der beiden Verbindungsabschnitte wiederum mit einem der beiden Kühlkörper einstückig verbunden ist, und wobei die Dicke jedes Verbindungsabschnitts in seinem an den Gelenkabschnitt angrenzenden Bereich der Dicke des Gelenkabschnitts entspricht und wobei dessen Dicke ausgehend davon in Richtung des Kühlkörpers, mit dem er einstückig verbunden ist, insbesondere kontinuierlich ansteigt bis sie der Dicke dieses Kühlkörpers entspricht.

Die beiden Drehachsen des Kühlkörpergelenks können im Bereich der gegenüberliegenden Seiten des Gelenkabschnitts angeordnet sein, die jeweils an den jeweiligen Verbindungsabschnitt angrenzen, oder an diesen Seiten.

Zur Erzeugung des erfindungsgemäßen Anpressdrucks, vgl. oben, kann die Kühleinrichtung eine Spanneinrichtung umfassen, mit der die Wärmeaufnahmefläche jedes Kühlkörpers gegen die Wärmeabgabefläche des zu kühlenden Gegenstands bzw. des jeweiligen zu kühlenden Gegenstands pressbar ist oder gepresst wird.

Der Kühlkörper kann im Übrigen zusammen mit dem oder den zu kühlenden Gegenständen in der Spanneinrichtung eingespannt oder einspannbar sein, insbesondere zwischen einem ersten, insbesondere bewegbaren, vorzugsweise elastische Spannbauteil und einem zweiten, insbesondere ortsfesten Spannbauteil.

Das erste Spannbauteil kann dabei mittels Federkraft gegen die Kühlkörper drückbar sein oder gedrückt werden.

Jeder Kühlkörper kann im Übrigen vorzugsweise fest und fluiddicht, insbesondere flüssigkeitsdicht, mit einem bevorzugt aus Kunststoff gebildeten, insbesondere gemeinsamen Grundkörper verbunden sein, insbesondere auf der von der oder den jeweiligen Wärmeaufnahmeflächen abgewandten Seite des jeweiligen Kühlkörpers, wobei der jeweilige Kühlkörper und der Grundkörper gemeinsam den Kühlfluidraum ganz oder teilweise umschließen oder nach außen hin begrenzen.

Der oder jeder zu kühlende Gegenstand kann des Weiteren auf einem ortsfesten Bauteil der Kühleinrichtung sitzen, insbesondere entweder unter unmittelbarer Anlage an diese auf einer bevorzugt ebenen Wärmeaufnahmefläche (insbesondere aus Metall) eines ortsfesten zweiten, insbesondere aus massivem Material bestehenden, mit Abstand zu den (ersten) Kühlkörpern angeordneten weiteren Kühlkörpers der Kühleinrichtung zur Aufnahme von Wärme der zu kühlenden Gegenstände oder unter Vermittlung einer Zwischenschicht aus Luft verdrängendem, vorzugsweise pastösem Material, insbesondere Wärmeleitmaterial, wie etwa Wärmeleitpaste.

Was den Kühlfluidraum der Kühleinrichtung betrifft, so kann er vorzugsweise aus einer Mehrzahl von in den jeweiligen Kühlkörper eingebrachten, insbesondere eingefrästen Fluidleitungen gebildet sein oder solche Fluidleitungen umfassen.

Weitere Merkmale der vorliegenden Erfindung ergeben sich aus den beigefügten Patentansprüchen, der nachfolgenden Beschreibung bevorzugter Ausführungsbeispiele, sowie aus den beigefügten Zeichnungen.

Darin zeigt:
- Fig. 1:: eine erfindungsgemäße Anordnung mit einer Kühleinrichtung und drei von dieser zu kühlenden Gegenständen in Schrägansicht,
- Fig. 2:: die Kühleinrichtung aus Fig. 1 in Seitenansicht,
- Fig. 3:: die Anordnung gemäß Fig. 1, allerdings mit drei zu kühlenden Gegenständen, von denen einer eine größere Höhe aufweist als die anderen beiden,
- Fig. 4:: eine weitere Ausführungsform einer erfindungsgemäßen Kühleinrichtung in einer Seitenansicht analog zu Fig. 2.

Die in den Figuren gezeigte Anordnung weist eine Kühleinrichtung 10 auf, die zum Abführen von Wärme von zu kühlenden Gegenständen 11 dient, im vorliegenden Fall Leistungselektronikbauteilen (etwa Wechselrichtermodule), wie sie beispielsweise im Zusammenhang mit Batterien bzw. Akkus von Elektrofahrzeugen verwendet werden.

Die Kühleinrichtung 10 verfügt über einen unteren Kühlkörper 12, auf dem die zu kühlenden Gegenstände 11 angeordnet sind bzw. sitzen und der die Unterseiten der zu kühlenden Gegenstände 11 kühlt bzw. Wärme von diesen aufnimmt, sowie über mehrere, vorliegend drei, obere Kühlkörper 20, 21, 22, die jeweils an den Oberseiten der zu kühlenden Gegenstände 11 anliegen und diese kühlen bzw. Wärme von deren Oberseiten aufnehmen.

Der untere Kühlkörper 12 sowie die oberen Kühlkörper 20, 21, 22 sind vorliegend jeweils als massive Metallkörper ausgebildet, beispielsweise aus Aluminium.

Der untere Kühlkörper 12 ist Teil eines unteren Kühlbauteils 14, das im Inneren (nicht gezeigt) über einen Kühlfluidraum verfügt, der nach außen von dem unteren Kühlkörper 12 und einem beispielsweise aus Kunststoff hergestellten Grundkörper begrenzt wird, wobei der untere Kühlkörper 12 und der ihm zugeordnete Grundkörper fluiddicht, vorliegend flüssigkeitsdicht, miteinander verbunden sind (etwa stoffschlüssig). In den Figuren sind der untere Kühlkörper 12 des unteren Kühlbauteils 14 und dessen Grundkörper der Einfachheit halber zeichnerisch nicht einzeln aufgelöst, sondern vielmehr als Gesamteinheit bzw. Gesamtblock dargestellt.

Die oberen Kühlkörper 20, 21, 22 sind Teil eines oberen Kühlbauteils 15, das ebenfalls im Inneren über einen nicht dargestellten Kühlfluidraum verfügt, der nach außen einerseits von den oberen Kühlkörpern 20, 21, 22 und andererseits von einem beispielsweise ebenfalls aus Kunststoff hergestellten, diesen oberen Kühlkörpern 20, 21, 22 gemeinsam zugeordneten Grundkörper 19 begrenzt wird. Auch die oberen Kühlkörper 20, 21, 22 und der ihnen gemeinsam zugeordnete Grundkörper 19 des oben Kühlbauteils 15 sind dabei fluiddicht, vorliegend ebenfalls flüssigkeitsdicht, miteinander verbunden (etwa stoffschlüssig).

Ein oder beide Kühlfluidräume können beispielsweise aus einer Mehrzahl von in den jeweiligen Kühlkörpern 12 bzw. 20, 21, 22 eingebrachten, insbesondere eingefrästen Fluidleitungen bestehen oder diese umfassen.

Das untere Kühlbauteil 14 und das obere Kühlbauteil 15, genauer gesagt die Kühlfluidräume derselben, sind vorliegend über seitlich angeordnete, insbesondere senkrecht zu ihnen verlaufende Verbindungsleitungen 16 fluidleitend miteinander verbunden.

Die Kühleinrichtung 10 verfügt des Weiteren über einen Mediumeinlass 17 sowie einen Mediumauslass 18.

Im Ergebnis kann entsprechend über den Mediumeinlass 17 zunächst dem unteren Kühlbauteil 14 und in der Folge auch dem oberen Kühlbauteil 15 Kühlfluid zugeführt werden, das im Betrieb der Kühleinrichtung 10 die (Ab-)Wärme abführen kann, die die Kühlkörper 12 bzw. 20, 21, 22 von den zu kühlenden Gegenständen 11 aufnehmen.

In der Regel wird es sich bei dem Kühlfluid um eine Kühlflüssigkeit handeln. Es versteht sich aber, dass es auch im Rahmen der Erfindung liegt, als Kühlfluid ein gasförmiges Medium zu verwenden. Die entsprechenden fluiddichten Verbindungen zwischen dem jeweiligen Grundkörper und dem unteren bzw. oberen Kühlkörper 12 bzw. 20, 21, 22 etc. müssten dann entsprechend gasdicht ausgebildet sein.

Erfindungsgemäß sind die oberen Kühlkörper 20, 21, 22 in besonderer Weise paarweise jeweils gelenkig miteinander verbunden, sodass sie relativ zueinander bewegbar sind. Dabei ist ein erstes Paar aus den oberen Kühlkörpern 20, 21 über ein erstes Kühlkörpergelenk 23 gelenkig miteinander verbunden und ein zweites Paar aus den oberen Kühlkörpern 21, 22 durch ein zweites Kühlkörpergelenk 24.

Jeder obere Kühlkörper 20, 21, 22 verfügt jeweils über eine ebene Unterseite, die jeweils eine (äußere) ebene bzw. plane Wärmeaufnahmefläche 25 bildet, die im Betrieb der Kühleinrichtung 10 an einer gegenüberliegenden, vorliegend ebenfalls ebenen, durch deren jeweilige Oberseite gebildete Wärmeabgabefläche 26 des jeweiligen zu kühlenden Gegenstands 11 anliegt bzw. dieser parallel gegenüberliegt.

Die gelenkigen Verbindungen der oberen Kühlkörper 20, 21, 22 ermöglichen bei Anlage bzw. Anordnung des jeweiligen oberen Kühlkörpers 20, 21, 22 an die zu kühlenden Gegenstände 11 einen besonderen Toleranzausgleich, wie nachfolgend näher ausgeführt wird.

Konkret können hierdurch beispielsweise auch etwas größere Unterschiede in den Höhenabmessungen der einzelnen zu kühlenden Gegenstände 11 ausgeglichen werden, deren Ausgleich etwa mittels Wärmeleitpaste aufgrund der hierfür notwendigen Schichtdicken mit Blick auf eine möglichst optimierte Wärmeleitung (zu) nachteilig wäre.

In einem solchen Fall größerer Höhenunterschiede (aber auch in anderen sinnvollen Fällen) können dann die einzelnen, ebenen Wärmeaufnahmeflächen 25 der jeweiligen oberen Kühlkörper 20, 21, 22 in verschiedene Ebenen bewegt werden, sodass sie dann trotz nicht in einer gemeinsamen Ebene verlaufender Wärmeabgabeflächen 26 der zu kühlenden Gegenstände 11 dennoch jeweils ohne oder nur mit geringstmöglichem Abstand der ihnen jeweils zugeordneten (ebenen) Wärmeabgabefläche 26 des jeweiligen zu kühlenden Gegenstands 11 unmittelbar gegenüberliegen.

Die hierfür notwendige Beweglichkeit zwischen den einzelnen oberen Kühlkörpern 20, 21, 22 wird, wie oben bereits angedeutet, durch die Kühlkörpergelenke 23 bzw. 24 ermöglicht.

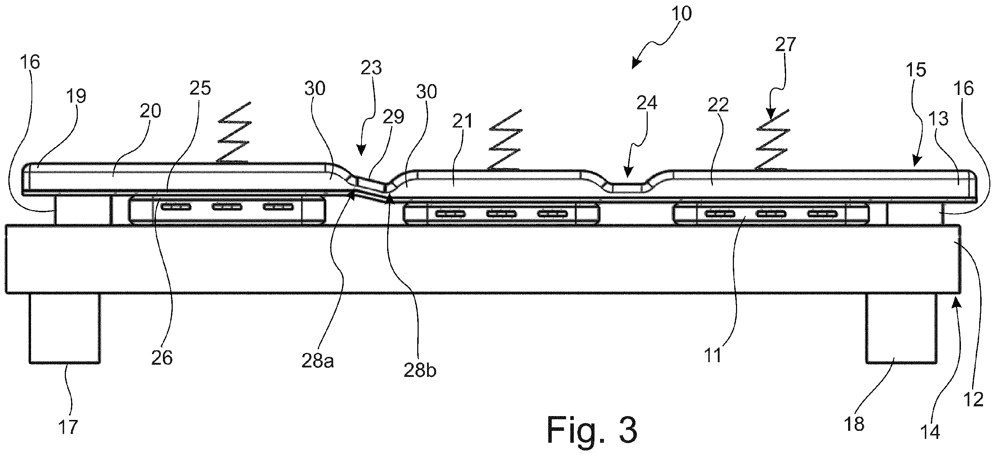

Zur weiteren Verdeutlichung ist in Fig. 3 eine Situation gezeigt, in der einer der zu kühlenden Gegenstände 11, nämlich der linke äußere zu kühlende Gegenstand 11, eine größere Höhe aufweist als die anderen beiden zu kühlenden Gegenstände 11. Entsprechend verläuft dessen Wärmeabgabefläche 26 in einer anderen (höheren) Ebene als die Wärmeabgabeflächen 26 der anderen beiden zu kühlenden Gegenstände 11.

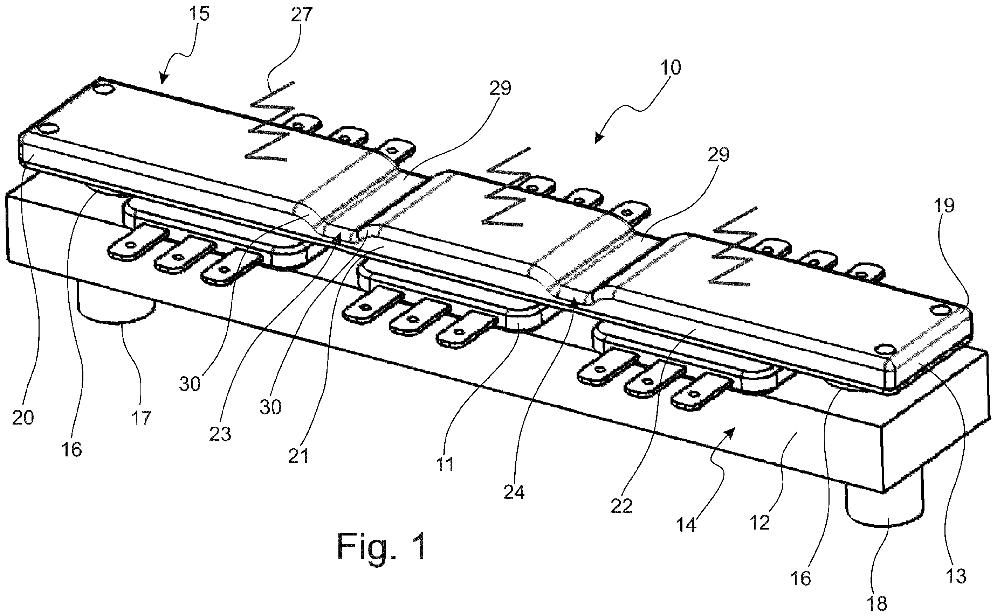

Um dies auszugleichen, wurde das obere Kühlbauteil 15 im Vergleich zur Situation der Fig. 1, in der sämtliche Wärmeaufnahmeflächen 25 des oberen Kühlbauteils 15 bzw. der oberen Kühlkörper 20, 21, 22 in einer gemeinsamen Ebene liegen, durch Aufbringen von Druck auf das obere Kühlbauteil 15 bzw. mittelbar auf die oberen Kühlkörper 20, 21, 22 verformt. Schematisch angedeutet sind Kräfte 27, die von oben auf das obere Kühlbauteil 15 bzw. entsprechend auf die oberen Kühlkörper 20, 21, 22 einwirken, um diese Verformung zu bewirken.

Konkret wirken diese Kräfte 27 auf die einzelnen oberen Kühlkörper 20, 21, 22 ein und sorgen insbesondere für eine Relativbewegung zwischen dem äußeren oberen Kühlkörper 20 und dem benachbarten, mittleren oberen Kühlkörper 21.

Zu diesem Zweck umfassen das erste und das zweite Kühlkörpergelenk 23 bzw. 24 jeweils einen mit den oberen Kühlkörper 20, 21, 22 einstückig verbundenen, beispielsweise plattenförmigen Gelenkabschnitt 29. Dieser verfügt über eine deutlich geringe Materialdicke als die beiden oberen Kühlkörper 20, 21 bzw. 21, 22, die das jeweilige Kühlkörpergelenk 23 bzw. 24 gelenkig miteinander verbindet.

Dabei ist die (geringere) Materialdicke derart gewählt, dass der jeweilige Gelenkabschnitt 29 insgesamt flexibel (verformbar) bzw. biegeweich ist. Im Bereich von gegenüberliegenden Seiten des jeweiligen Gelenkabschnitts 29 bilden sich dabei jeweils definierte, voneinander beabstandete, parallele Drehachsen 28a bzw. 28b aus, die vorliegend parallel zu der Ebene der jeweiligen Wärmeaufnahmefläche 25 verlaufen, und um die die Kühlkörper 20, 21, 22 jeweils (durch Verformung des Gelenkabschnitts 29 in diesem Bereich) drehbar sind.

Im Bereich beider gegenüberliegender Seiten des jeweiligen Gelenkabschnitts 29 grenzt dieser im Übrigen jeweils an einen mit den beiden oberen Kühlkörpern 20, 21 bzw. 21, 22 eines Paares benachbarter Kühlkörper 20, 21, 22 einstückig verbundenen Verbindungsabschnitt 30 an, dessen Dicke in seinem an den Gelenkabschnitt 29 angrenzenden Bereich der Dicke des Gelenkabschnitts 29 entspricht und dessen Dicke ausgehend davon in Richtung des jeweiligen Kühlkörpers 20, 21 bzw. 22 insbesondere kontinuierlich ansteigt bis sie der Dicke des Kühlkörpers 20, 21 bzw. 22 entspricht.

Was die oben genannte Relativbewegung zwischen dem äußeren oberen Kühlkörper 20 und dem benachbarten, mittleren oberen Kühlkörper 21 betrifft, so ermöglicht sie eine entsprechende Ausrichtung bzw. Bewegung der einzelnen Kühlkörper 20 und 21 derart, dass anschließend sowohl die Wärmeaufnahmefläche 25 des äußeren oberen Kühlkörpers 20 als auch die Wärmeaufnahmefläche 25 des mittleren oberen Kühlkörpers 21 jeweils an der ihnen zugeordneten Wärmeabgabefläche 26 des jeweiligen zu kühlenden Gegenstands 11 anliegen (Fig. 3).

Die vorgenannten Kräfte 27 werden im vorliegenden Beispiel von einer nicht dargestellten Spanneinrichtung aufgebracht, in der das untere und das obere Kühlbauteil 14 bzw. 15 zusammen mit den zwischen ihnen angeordneten zu kühlenden Gegenständen 11 zwischen einem ersten, insbesondere bewegbaren, vorzugsweise als Feder ausgebildeten Spannbauteil und einem zweiten, insbesondere ortsfesten Spannbauteil eingespannt ist.

Dabei kann im Übrigen auch vorgesehen sein, dass beispielsweise das untere Kühlbauteil 14 gleichzeitig das zweite, ortsfeste Spannbauteil bildet.

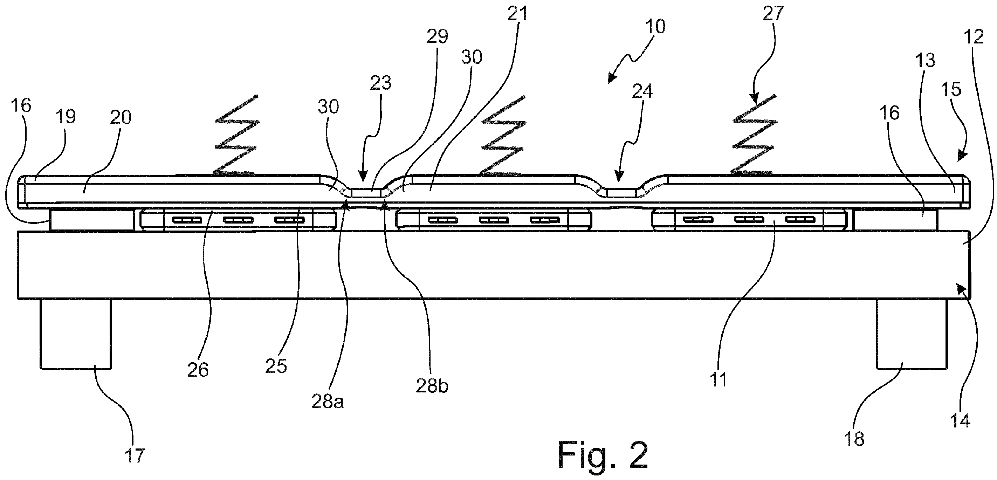

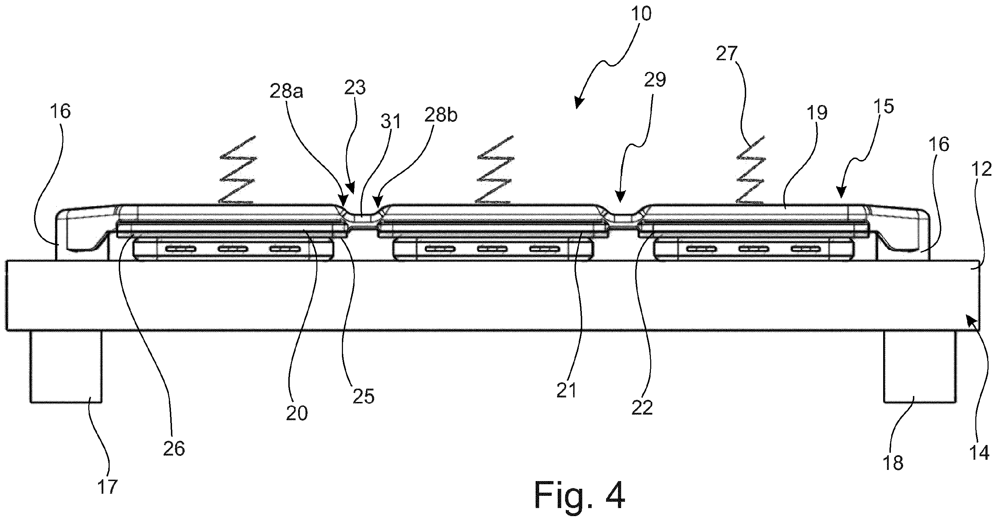

In Figur 4 ist eine Ausführungsform einer erfindungsgemäßen Kühleinrichtung 10 gezeigt, in der die einzelnen Kühlkörper 20, 21, 22 in anderer Weise als in den Figuren 1-3 miteinander gelenkig verbunden sind. Nämlich nicht unmittelbar über einen einstückig mit ihnen verbundenen Gelenkabschnitt 29 bzw. Verbindungsabschnitt 30, sondern nur mittelbar über einen flexiblen, zwischen den Paaren von Kühlkörpern 20, 21 bzw. 21, 22 angeordneten Gelenkabschnitt 31, der in diesem Fall Teil des mit den oberen Kühlkörpern 20, 21, 22 (fluiddicht) verbundenen Grundkörpers 19 aus Kunststoff ist bzw. einstückig mit diesem verbunden ist.

Die oberen Kühlkörper 20, 21, 22 sind in diesem Fall insofern materialbezogen separate bzw. separat hergestellte Bauteile, die (nur) durch den gemeinsamen Grundkörper 19 miteinander verbunden wurden bzw. sind, während sie in der Ausführungsform der Figuren 1-3 aus einem gemeinsamen Material- bzw. Metallblock hergestellt sind, in den durch geeignete Bearbeitung des Materialblocks die Verbindungabschnitte 30 bzw. die Gelenkabschnitte 29 eingearbeitet wurden bzw. sind, sodass die oberen Kühlkörper 20, 21, 22 im Ergebnis entsprechend einstückig miteinander verbunden sind.

In besonderer Weise ist erfindungsgemäß die Wärmeleitung zwischen den Wärmeabgabeflächen 26 und den Wärmeaufnahmeflächen 25 weiter optimiert.

Sowohl die Wärmeabgabeflächen 26 als auch die Wärmeaufnahmeflächen 25 sind mittels Ultrafeinbearbeitung, wie etwa Läppen, Hönen, Diamantfräsen, ultraeben ausgebildet und weisen Rauheitswerte Ra < 0,3 µm und/oder Ebenheitswerte < 0,5 µm auf.

In Kombination mit einem Anpressdruck von mindestens 0,05 N/mm², mit dem die Wärmeaufnahmeflächen 25 und die Wärmeabgabeflächen 26 entsprechend gegeneinander gepresst sind und der mittels der Spanneinrichtung aufgebracht wird, führt dies dazu, wie eingangs dieser Anmeldung bereits ausführlich beschrieben, dass sich das Metall der Wärmeabgabefläche 26 und das Metall der Wärmeaufnahmefläche 25 entweder vollflächig oder mindestens in überwiegenden Teilbereichen direkt kontaktiert, ohne dass sich - anders als im Stand der Technik - Luftpolster zwischen den Flächen 25 bzw. 26 aufbauen würden, die ansonsten durch eine vergleichsweise dicke Schicht aus Luft verdrängendem Material, insbesondere Wärmeleitmaterial, verdrängt werden müsste, die sich mit Blick auf die Wärmeleitfähigkeit negativ auswirken würde.

Auf eine solche Zwischenschicht aus im Vergleich zu einem reinen Metall-Metall-Kontakt naturgemäß bzw. materialbedingt regelmäßig deutlich schlechter leitendem Material kann daher verzichtet werden. Falls eine solche Zwischenschicht dennoch eingesetzt wird, kann diese aufgrund der erfindungsgemäßen Rauheits- und/oder Ebenheitswerte und/oder des erfindungsgemäßen Anpressdrucks sehr dünn ausgebildet sein und beispielsweise nur eine Maximaldicke < 2 µm aufweisen.

### Bezugszeichenliste:

- 10: Kühleinrichtung
- 11: zu kühlender Gegenstand
- 12: unterer Kühlkörper
- 14: unteres Kühlbauteil
- 15: oberes Kühlbauteil
- 16: Verbindungsleitung
- 17: Mediumeinlass
- 18: Mediumauslass
- 19: Grundkörper oberes Kühlbauteil
- 20: äußerer oberer Kühlkörper
- 21: mittlerer oberer Kühlkörper
- 22: äußerer oberer Kühlkörper
- 23: erstes Kühlkörpergelenk
- 24: zweites Kühlkörpergelenk
- 25: Wärmeaufnahmefläche
- 26: Wärmeabgabefläche
- 27: Kraft
- 28a: Drehachse
- 28b: Drehachse
- 29: Gelenkabschnitt
- 30: Verbindungsabschnitt
- 31: Gelenkabschnitt

## Patentansprüche

1. Anordnung mit einer Kühleinrichtung zum Abführen von Wärme von zu kühlenden Gegenständen, wie etwa von Leistungselektronikmodulen, die mindestens einen vorzugsweise starren, eine vorzugsweise ebene Wärmeaufnahmefläche aus Metall aufweisenden Kühlkörper (20, 21, 22) zur Aufnahme von Wärme eines oder mehrerer zu kühlender Gegenstände aufweist sowie einen Kühlfluidraum zur Aufnahme von Kühlfluid, insbesondere Kühlflüssigkeit, an das die von dem Kühlkörper (20, 21, 22) aufgenommene Wärme weiterleitbar ist, und mit mindestens einem, eine vorzugsweise ebene Wärmeabgabefläche aus Metall aufweisenden zu kühlenden Gegenstand, insbesondere einem Leistungselektronikmodul, **dadurch gekennzeichnet, dass** zur Optimierung der Wärmeleitung zwischen dem Kühlkörper (20, 21, 22) und dem zu kühlenden Gegenstand die Wärmeaufnahmefläche des Kühlkörpers (20, 21, 22) ohne Verwendung einer Zwischenschicht aus Luft verdrängendem Material, insbesondere Wärmeleitmaterial, unmittelbar an der Wärmeabgabefläche des zu kühlenden Gegenstands anliegt oder allenfalls unter Verwendung einer allerdings nur dünnen Zwischenschicht aus Luft verdrängendem Material, insbesondere Wärmeleitmaterial, mit einer Maximaldicke < 2 µm, wobei
a) die Wärmeaufnahmefläche des Kühlkörpers (20, 21, 22) und/oder die Wärmeabgabefläche des zu kühlenden Gegenstands derart bearbeitet ist, dass sie eine Rauheit Ra < 0,3 µm und/oder eine Ebenheit < 0,5 µm aufweist, und/oder wobei
b) die Wärmeaufnahmefläche des Kühlkörpers (20, 21, 22) und die Wärmeabgabefläche des zu kühlenden Gegenstands mit einem Anpressdruck von mindestens 0,05 N/mm² aneinandergepresst sind.

2. Anordnung gemäß Anspruch 1, **dadurch gekennzeichnet, dass** die Wärmeaufnahmefläche des Kühlkörpers (20, 21, 22) und/oder die Wärmeabgabefläche des zu kühlenden Gegenstands derart bearbeitet ist, dass sie eine Rauheit Ra < 0,1 µm und/oder eine Ebenheit < 0,1 µm aufweist, und/oder dass die Zwischenschicht aus dem Luft verdrängendem Material eine Maximaldicke < 40 nm, bevorzugt < 25 nm, besonders bevorzugt < 10 nm aufweist.

3. Anordnung gemäß einem oder mehreren der vorhergehenden Ansprüche, **dadurch gekennzeichnet, dass** sich die Wärmeabgabefläche des zu kühlenden Gegenstands und die Wärmeaufnahmefläche des Kühlkörpers (20, 21, 22) parallel gegenüberliegen.

4. Anordnung gemäß einem oder mehreren der vorhergehenden Ansprüche, **dadurch gekennzeichnet, dass** die Kühleinrichtung über mindestens zwei vorzugsweise starre Kühlkörper (20, 21, 22) verfügt, die jeweils eine insbesondere durch ihre Unterseite gebildete, insbesondere ebene Wärmeaufnahmefläche aufweisen, und die insbesondere über ein Kühlkörpergelenk (23, 24) gelenkig miteinander verbunden sind, sodass die beiden Kühlkörper (20, 21, 22) und mit ihnen die Wärmeaufnahmeflächen relativ zueinander in verschiedene, insbesondere parallele Ebenen bewegbar sind, wobei für jede Wärmeaufnahmefläche jedes Kühlkörpers (20, 21, 22) gilt, dass sie jeweils an der Wärmeabgabefläche eines von zwei zu kühlenden Gegenständen ohne Verwendung der jeweiligen Zwischenschicht aus dem Luft verdrängenden Material unmittelbar anliegt oder allenfalls unter Verwendung der nur dünnen Zwischenschicht aus dem Luft verdrängenden Material.

5. Anordnung gemäß Anspruch 4, **dadurch gekennzeichnet, dass** die Wärmeabgabeflächen der beiden zu kühlenden Gegenstände in verschiedenen, insbesondere parallelen Ebenen angeordnet sind, und dass die ebenen Wärmeaufnahmeflächen der Kühlkörper (20, 21, 22), die an den Wärmeabgabeflächen anliegen, entsprechend ebenfalls in verschiedenen, insbesondere parallelen Ebenen angeordnet sind.

6. Anordnung gemäß Anspruch 4 oder 5, **dadurch gekennzeichnet, dass** das Kühlkörpergelenk (23, 24) zwei voneinander beabstandete, insbesondere parallele Drehachsen aufweist, um die die beiden Kühlkörper (20, 21, 22) relativ zueinander in die verschiedenen Ebenen bewegbar, nämlich verschwenkbar sind.

7. Anordnung gemäß Anspruch 4, 5 oder 6, **dadurch gekennzeichnet, dass** das Kühlkörpergelenk (23, 24) einen flexiblen, insbesondere biegeweichen, bevorzugt plattenförmig ausgebildeten Gelenkabschnitt aufweist, der entweder einstückig mit den Kühlkörpern (20, 21, 22) verbunden ist und dabei über eine geringere Materialdicke verfügt als die beiden Kühlkörper (20, 21, 22), oder der einstückig verbunden ist mit einem Grundkörper, insbesondere aus Kunststoff, der mit den beiden Kühlkörpern (20, 21, 22) insbesondere fluiddicht verbunden ist.

8. Anordnung gemäß Anspruch 7, **dadurch gekennzeichnet, dass** der flexible Gelenkabschnitt an zwei gegenüberliegenden Seiten jeweils angrenzt an einen von zwei Verbindungsabschnitten, mit dem er einstückig verbunden ist, wobei jeder der beiden Verbindungsabschnitte wiederum mit einem der beiden Kühlkörper (20, 21, 22) einstückig verbunden ist, und wobei die Dicke jedes Verbindungsabschnitts in seinem an den Gelenkabschnitt angrenzenden Bereich der Dicke des Gelenkabschnitts entspricht und wobei dessen Dicke ausgehend davon in Richtung des Kühlkörpers (20, 21, 22), mit dem er einstückig verbunden ist, insbesondere kontinuierlich ansteigt bis sie der Dicke dieses Kühlkörpers (20, 21, 22) entspricht.

9. Anordnung gemäß einem oder mehreren der vorhergehenden Ansprüche 4-8, **dadurch gekennzeichnet, dass** die beiden Drehachsen des Kühlkörpergelenks (23, 24) im Bereich der gegenüberliegenden Seiten des Gelenkabschnitts angeordnet sind, die jeweils an den jeweiligen Verbindungsabschnitt angrenzen, oder an diesen Seiten.

10. Anordnung gemäß einem oder mehreren der vorhergehenden Ansprüche, **dadurch gekennzeichnet, dass** die Kühleinrichtung zum Erzeugen des Anpressdrucks eine Spanneinrichtung umfasst, mit der die Wärmeaufnahmefläche jedes Kühlkörpers (20, 21, 22) gegen die Wärmeabgabefläche des zu kühlenden Gegenstands bzw. des jeweiligen zu kühlenden Gegenstands pressbar ist oder gepresst wird.

11. Anordnung gemäß Anspruch 10, **dadurch gekennzeichnet, dass** jeder Kühlkörper (20, 21, 22) zusammen mit dem oder den zu kühlenden Gegenständen in der Spanneinrichtung eingespannt ist oder einspannbar ist, insbesondere zwischen einem ersten, insbesondere bewegbaren, vorzugsweise elastische Spannbauteil und einem zweiten, insbesondere ortsfesten Spannbauteil.

12. Anordnung gemäß Anspruch 11, **dadurch gekennzeichnet, dass** das erste Spannbauteil mittels Federkraft gegen die Kühlkörper (20, 21, 22) drückbar ist oder gedrückt wird.

13. Anordnung gemäß einem oder mehreren der vorhergehenden Ansprüche, **dadurch gekennzeichnet, dass** jeder Kühlkörper (20, 21, 22) fest und fluiddicht, insbesondere flüssigkeitsdicht, mit einem oder dem insbesondere gemeinsamen, bevorzugt aus Kunststoff gebildetem Grundkörper verbunden ist, insbesondere auf der von der oder der jeweiligen Wärmeaufnahmefläche abgewandten Seite des jeweiligen Kühlkörpers (20, 21, 22), wobei der jeweilige Kühlkörper (20, 21, 22) und der Grundkörper gemeinsam den Kühlfluidraum ganz oder teilweise umschließen oder nach außen hin begrenzen.

14. Anordnung gemäß einem oder mehreren der vorhergehenden Ansprüche 4-13, **dadurch gekennzeichnet, dass** der oder jeder zu kühlende Gegenstand auf einem ortsfesten Bauteil der Kühleinrichtung sitzen, insbesondere entweder unter unmittelbarer Anlage an diese auf einer bevorzugt ebenen Wärmeaufnahmefläche eines ortsfesten zweiten, insbesondere aus massivem Material bestehenden, mit Abstand zu den (ersten) Kühlkörpern (20, 21, 22) angeordneten weiteren Kühlkörpers (12) der Kühleinrichtung zur Aufnahme von Wärme der zu kühlenden Gegenstände oder unter Vermittlung einer Zwischenschicht aus Luft verdrängendem Material, insbesondere Wärmeleitmaterial.

## Claims

1. Arrangement having a cooling device for removing heat from objects to be cooled, such as power electronics modules, which has at least one preferably rigid cooling body (20, 21, 22) which has a preferably flat heat absorption surface made of metal and is intended for absorbing heat from one or more objects to be cooled, and a cooling-fluid space for receiving cooling fluid, in particular cooling liquid, to which the heat absorbed by the cooling body (20, 21, 22) can be conducted, and with at least one object to be cooled, in particular a power electronics module, which preferably has a flat heat emission surface made of metal, **characterized in that,** to optimize the heat conduction between the cooling body (20, 21, 22) and the object to be cooled, the heat absorption surface of the cooling body (20, 21, 22) directly adjoins the heat emission surface of the object to be cooled without the use of an intermediate layer of air-displacing material, in particular heat-conducting material, or at most with the use of an intermediate layer, however only a thin one, of air-displacing material, in particular heat-conducting material, with a maximum thickness of < 2µm, wherein
a) the heat absorption surface of the cooling body (20, 21, 22) and/or the heat emission surface of the object to be cooled is processed in such a way that it has a roughness Ra < 0.3 µm and/or a flatness < 0.5 µm, and/or wherein
b) the heat absorption surface of the cooling body (20, 21, 22) and the heat emission surface of the object to be cooled are pressed against each other with a contact pressure of at least 0.05 N/mm².

2. Arrangement according to claim 1, **characterized in that** the heat absorption surface of the cooling body (20, 21, 22) and/or the heat emission surface of the object to be cooled is processed in such a way that it has a roughness Ra < 0.1 µm and/or a flatness < 0.1 µm, and/or that the intermediate layer of air-displacing material has a maximum thickness < 40 nm, preferably < 25 nm, particularly preferably < 10 nm.

3. Arrangement according to one or more of the preceding claims, **characterized in that** the heat emission surface of the object to be cooled and the heat absorption surface of the cooling body (20, 21, 22) are located opposite one another in parallel.

4. Arrangement according to one or more of the preceding claims, **characterized in that** the cooling device has at least two preferably rigid cooling bodies (20, 21, 22) which in each case have a heat absorption surface, in particular a flat heat absorption surface formed in particular by their bottom surface, and which are connected to one another in an articulated manner in particular via a cooling-body joint (23, 24), so that the two cooling bodies (20, 21, 22) and, with them, the heat absorption surfaces can be moved relative to one another in different, in particular parallel, planes, wherein each heat absorption surface of each cooling body (20, 21, 22) is in direct contact with the heat emission surface of one of two objects to be cooled without the use of the associated intermediate layer of air-displacing material or, at most, with the use of only a thin intermediate layer of the air-displacing material.

5. Arrangement according to claim 4, **characterized in that** the heat emission surfaces of the two objects to be cooled are arranged in different, in particular parallel, planes, and **in that** the planar heat absorption surfaces of the cooling bodies (20, 21, 22), which abut the heat emission surfaces, are arranged correspondingly as well in different, in particular parallel, planes.

6. Arrangement according to claim 4 or 5, **characterized in that** the cooling body joint (23, 24) has two axes of rotation, which are spaced apart from one another and, in particular, are parallel, about which the two cooling bodies (20, 21, 22) can be moved, namely pivoted, relative to one another into the different planes.

7. Arrangement according to claim 4, 5 or 6, **characterized in that** the cooling body joint (23, 24) has a flexible, in particular pliable, preferably plate-shaped joint section, which is either connected in one piece to the cooling bodies (20, 21, 22) and in this case has a smaller material thickness than the two cooling bodies (20, 21, 22), or which is connected in one piece to a basic body, in particular made of plastic, which is connected to the two cooling bodies (20, 21, 22), in particular in a fluid-tight manner.

8. Arrangement according to claim 7, **characterized in that** the flexible joint section is adjacent in each case to one of two connection sections on two sides located opposite one another, to which it is integrally connected, wherein each of the two connection sections, on the other hand, is connected in one piece to one of the two cooling bodies (20, 21, 22), and wherein the thickness of each connection section in its area adjacent to the joint section corresponds to the thickness of the joint section and wherein its thickness increases, in particular continuously, from there in the direction of the cooling body (20, 21, 22) to which it is connected in one piece, until it corresponds to the thickness of said cooling body (20, 21, 22).

9. Arrangement according to one or more of the preceding claims 4-8, **characterized in that** the two rotation axes of the cooling body joint (23, 24) are arranged in the area of the opposing sides of the joint section, each of which being adjacent to the associated connection section, or to these sides.

10. Arrrangement according to one or more of the preceding claims, **characterized in that** the cooling device for generating the contact pressure comprises a clamping device with which the heat absorption surface of each cooling body (20, 21, 22) can be or is pressed against the heat emission surface of the object to be cooled or of the associated object to be cooled.

11. Arrangement according to claim 10, **characterized in that** each cooling body (20, 21, 22) is clamped or can be clamped in the clamping device together with the object or objects to be cooled, in particular between a first, in particular movable, preferably elastic clamping component and a second, in particular stationery clamping component.

12. Arrangement according to claim 11, **characterized in that** the first clamping component can be pressed or is pressed against the cooling bodies (20, 21, 22) by means of spring force.

13. Arrangement according to one or more of the preceding claims, **characterized in that** each cooling body (20, 21, 22) is firmly and in a fluid-tight, in particular liquid-tight manner connected to one or the in particular common basic body, preferably formed from plastic, in particular on the side of the associated cooling body (20, 21, 22) facing away from the or the associated heat absorption surface, wherein the associated cooling body (20, 21, 22) and the basic body together completely or partially enclose the cooling fluid space or delimit it towards the outside.

14. Arrangement according to one or more of the preceding claims 4-13, **characterized in that** the object or each object to be cooled is placed on a stationary component of the cooling device, in particular either in direct contact with the latter on a preferably flat heat absorption surface of a stationary second, further cooling body (12) of the cooling device, in particular consisting of solid material, arranged at a distance from the (first) cooling bodies (20, 21, 22) for receiving heat from the objects to be cooled, or with the interposition of an intermediate layer of an air-displacing material, in particular a heat-conducting material.

## Revendications

1. Agencement avec un dispositif de refroidissement pour évacuer la chaleur d'objets à refroidir, comme par exemple des modules électroniques de puissance, qui comprend au moins un corps de refroidissement (20, 21, 22) de préférence rigide, présentant une surface d'absorption de chaleur, de préférence plane, en métal, destiné à recevoir la chaleur d'un ou de plusieurs objets à refroidir, ainsi qu'un espace pour fluide de refroidissement destiné à recevoir un fluide de refroidissement, en particulier un liquide de refroidissement, auquel la chaleur reçue par le corps de refroidissement (20, 21, 22) peut être transmise, et avec au moins un objet à refroidir présentant une surface d'émission de chaleur en métal, de préférence plane, en particulier un module électronique de puissance, **caractérisé en ce que**, pour optimiser la conduction thermique entre le corps de refroidissement (20, 21, 22) et l'objet à refroidir, la surface d'absorption de chaleur du corps de refroidissement (20, 21, 22) s'applique directement sur la surface d'émission de chaleur de l'objet à refroidir sans utilisation d'une couche intermédiaire en matériau déplaçant l'air, en particulier en matériau conducteur de chaleur, ou tout au plus en utilisant une couche intermédiaire, toutefois seulement mince, en matériau déplaçant l'air, en particulier en matériau conducteur de chaleur, avec une épaisseur maximale < 2 µm, dans lequel
a) la surface d'absorption de chaleur du corps de refroidissement (20, 21, 22) et/ou la surface d'émission de chaleur de l'objet à refroidir est traitée de telle sorte qu'elle présente une rugosité Ra < 0,3 µm et/ou une planéité < 0,5 µm, et/ou dans lequel
b) la surface d'absorption de chaleur du corps de refroidissement (20, 21, 22) et la surface d'émission de chaleur de l'objet à refroidir sont pressées l'une contre l'autre avec une pression de contact d'au moins 0,05 N/mm².

2. Agencement selon la revendication 1, **caractérisé en ce que** la surface d'absorption de chaleur du corps de refroidissement (20, 21, 22) et/ou la surface d'émission de chaleur de l'objet à refroidir est traitée de manière à présenter une rugosité Ra < 0,1 µm et/ou une planéité < 0,1 µm, et/ou **en ce que** la couche intermédiaire du matériau déplaçant l'air présente une épaisseur maximale < 40 nm, de préférence < 25 nm, de manière particulièrement préférée < 10 nm.

3. Agencement selon l'une ou plusieurs des revendications précédentes, **caractérisé en ce que** la surface d'émission de chaleur de l'objet à refroidir et la surface d'absorption de chaleur du corps de refroidissement (20, 21, 22) sont parallèles et opposées.

4. Agencement selon l'une ou plusieurs des revendications précédentes, **caractérisé en ce que** le dispositif de refroidissement dispose d'au moins deux corps de refroidissement (20, 21, 22), de préférence rigides, qui présentent chacun une surface d'absorption de chaleur, en particulier plane, formée en particulier par leur face inférieure, et qui sont reliés entre eux de manière articulée, en particulier par une articulation de refroidissement (23, 24), de telle sorte que les corps de refroidissement (20, 21, 22) sont reliés entre eux de manière articulée et avec eux les surfaces d'absorption de chaleur peuvent être déplacés l'un par rapport à l'autre dans différents plans, en particulier parallèles, dans lequel pour chaque surface d'absorption de chaleur de chaque corps de refroidissement (20, 21, 22) vaut que elle s'applique directement à la surface d'émission de chaleur de l'un des deux objets à refroidir sans utiliser la couche intermédiaire respective en matériau déplaçant l'air ou tout au plus en utilisant la couche intermédiaire seulement mince en matériau déplaçant l'air.

5. Agencement selon la revendication 4, **caractérisé en ce que** les surfaces d'émission de chaleur des deux objets à refroidir sont disposées dans des plans différents, notamment parallèles, et **en ce que** les surfaces planes d'absorption de chaleur des corps de refroidissement (20, 21, 22), qui s'appliquent contre les surfaces d'émission de chaleur, sont également disposées en conséquence dans des plans différents, notamment parallèles.

6. Agencement selon la revendication 4 ou 5, **caractérisé en ce que** l'articulation (23, 24) du corps de refroidissement présente deux axes de rotation espacés l'un de l'autre, notamment parallèles, autour desquels les deux corps de refroidissement (20, 21, 22) peuvent être déplacés, notamment pivotés, l'un par rapport à l'autre dans les différents plans.

7. Agencement selon la revendication 4, 5 ou 6, **caractérisé en ce que** l'articulation (23, 24) du corps de refroidissement présente une section d'articulation flexible, en particulier souple, de préférence en forme de plaque, qui est soit reliée d'un seul tenant aux corps de refroidissement (20, 21, 22) et dispose alors d'une épaisseur de matériau inférieure à celle des deux corps de refroidissement (20, 21, 22), soit reliée en une pièce à un corps de base, en particulier en matière plastique, qui est relié aux deux corps de refroidissement (20, 21, 22), en particulier de manière étanche aux fluides.

8. Agencement selon la revendication 7, **caractérisé en ce que** la section d'articulation flexible est adjacente, sur deux côtés opposés, respectivement à l'une de deux sections de liaison avec laquelle elle est reliée d'un seul tenant, chacune des deux sections de liaison étant à son tour reliée d'un seul tenant à l'un des deux corps de refroidissement (20, 21, 22), et l'épaisseur de chaque section de liaison correspondante, dans sa section adjacente à la section d'articulation, à l'épaisseur de la section d'articulation et l'épaisseur de celle-ci augmentant notamment de façon continue à partir de celle-ci en direction du corps de refroidissement (20, 21, 22) avec lequel elle est solidaire, jusqu'à correspondre à l'épaisseur de ce corps de refroidissement (20, 21, 22).

9. Agencement selon l'une ou plusieurs des revendications précédentes 4 à 8, **caractérisé en ce que** les deux axes de rotation de l'articulation (23, 24) du corps refroidissement sont situés au niveau des côtés opposés de la section d'articulation, respectivement adjacents à la section de liaison respective, ou sur ces côtés.

10. Agencement selon l'une ou plusieurs des revendications précédentes, **caractérisé en ce que** le dispositif de refroidissement destiné à générer la pression de serrage comprend un dispositif de serrage permettant de presser ou d'appuyer la surface d'absorption de chaleur de chaque corps de refroidissement (20, 21, 22) contre la surface d'émission de chaleur de l'objet à refroidir ou de l'objet respectif à refroidir.

11. Agencement selon la revendication 10, **caractérisé en ce que** chaque corps de refroidissement (20, 21, 22) est serré ou peut être serré dans le dispositif de serrage avec le ou les objets à refroidir, en particulier entre un premier élément de serrage, en particulier mobile, de préférence élastique, et un deuxième élément de serrage, en particulier fixe.

12. Agencement selon la revendication 11, **caractérisé en ce que** le premier élément de serrage peut être pressé ou est pressé contre les corps de refroidissement (20, 21, 22) au moyen d'une force élastique.

13. Agencement selon une ou plusieurs des revendications précédentes, **caractérisé en ce que** chaque corps de refroidissement (20, 21, 22) est relié de manière fixe et étanche aux fluides, en particulier de manière étanche aux liquides, à un corps de base ou au corps de base en particulier commun, de préférence en matière plastique, en particulier sur le côté du corps de refroidissement (20, 21, 22) respectif opposé à la ou aux surfaces d'absorption de chaleur respectives, le corps de refroidissement (20, 21, 22) respectif et le corps de base ensemble entourant entièrement ou partiellement l'espace de fluide de refroidissement ou le délimitant vers l'extérieur.

14. Agencement selon l'une ou plusieurs des revendications 4 à 13 précédentes, **caractérisé en ce que** le ou chaque objet à refroidir est placé sur un élément fixe du dispositif de refroidissement, notamment soit en étant en contact direct avec celui-ci, sur une surface d'absorption de chaleur, de préférence plane, d'un deuxième élément fixe, en particulier en matériau massif, disposé à distance des (premiers) corps de refroidissement (20, 21, 22), pour recevoir la chaleur des objets à refroidir, soit par l'intermédiaire d'une couche intermédiaire en matériau déplaçant l'air, en particulier en matériau conducteur de chaleur.
